# EUROPÄISCHE PATENTSCHRIFT

(11) **EP 1 035 323 B1**
(45) Veröffentlichungstag und Bekanntmachung des Hinweises auf die Patenterteilung: **15.03.2006**
(21) Anmeldenummer: 99124265.2
(22) Anmeldetag: 04.12.1999
(51) Int. Cl.: F02P 17/12, G01R 31/38, G01R 15/16

(54) **Vorrichtung zum Erfassen von Signalen an einer Zündanlage**
Device for evaluating signals for an ignition system
Dispositif pour la saisie de signaux pour un circuit d'allumage

(30) Priorität: 10.03.1999 DE 19910416
(43) Veröffentlichungstag der Anmeldung: 13.09.2000
(73) Patentinhaber: ROBERT BOSCH GMBH, 70442 Stuttgart (DE)
(72) Erfinder: Bumen, Werner, 73230 Kirchheim (DE)

(56) Entgegenhaltungen:
- WO-A-92/10674
- DE-A- 2 149 307
- DE-A- 4 443 304
- US-A- 3 938 113

## Beschreibung

### Stand der Technik

Die Erfindung betrifft eine Vorrichtung zum Erfassen von Signalen an einer Zündanlage mit den im Oberbegriff des Anspruchs 1 angegebenen Merkmalen.

Eine derartige Vorrichtung ist beispielsweise aus der DE 44 43 304 A1 bekannt. Die dort gezeigte Vorrichtung umfaßt einen Adapter aus Kunststoff in dem eine für die kapazitive Signalauskopplung vorgesehene Sensorelektronde angeordnet ist, die über eine Verbindungsleitung mit einer elektronischen Diagnoseschaltung elektrisch verbunden ist. Der Adapter wird in einer Haltevorrichtung an einem vorgegebenen Meßpunkt an der Zündspule befestigt. Eine ähnliche Anordnung ist aus der WO 92/10674 bekannt. Hier besteht der Adapter aus einem abgewinkelten Blechteil, welches direkt auf die Zündspule aufgesetzt ist.

Die Zündspule weist eine Primärwicklung und eine die Primärwicklung umgebende Sekundärwicklung auf, die beide in eine Isolierstoffumhüllung eingebracht sind, durch welche die Spule nach außen isoliert ist. Bei hohen Zündspannungen und den daraus resultierenden hohen Feldstärken treten auf der Oberfläche der Isolierstoffumhüllung Entladungsströme beziehungsweise Oberflächenströme auf. In Abhängigkeit von den verwendeten Isolierstoffen, der Temperatur und auf der Isolierstoffumhüllung vorhandenen Verunreinigungen können die Oberflächenströme auf der Isolierstoffumhüllung stark variieren. Die aus der WO 92/10674 bekannten Blechadapter zur kapazitiven Signalauskopplung weisen keinen Schutz gegen das Ableiten der Störströme über die Sensorelektrode auf, so dass die Störströme unmittelbar auf die Diagnoseschaltung übertragen werden und eine zuverlässige Zündsignaldiagnose unmöglich machen. Auch die aus der DE 44 43 304 A1 bekannten Adapter mit den in Kunststoff eingebetteten Sensorelektroden sind nicht ausreichend geschützt. Aus den hohen Feldstärken resultieren Entladungsströme, die über die Sensorelektrode zur Diagnoseschaltung abfließen und zu Signalverfälschungen führen.

Ein Adapter zur kapazitiven Signalkopplung wird in US 3938113 beschrieben. Der Adapter dient zum Kodieren von Sensorsignalen eines Tintenstrahldrucker und einer Typenradschreibmaschine. Der Adapter zur kapazitiven Signalauskopplung umfasst eine Isolierstoffplatte, die auf einer Seite mit einer die Sensorelektrode bildenden ersten Leiterbahn und mit einer die erste Leiterbahn teilweise umgebenden und durch einen Spalt von der ersten Leiterbahn isolierten zweiten Leiterbahn versehen ist. Die zweite Leiterbahn ist dabei mit einem Masseanschluss elektrisch verbunden.

### Vorteile der Erfindung

Die erfindungsgemäße Vorrichtung zum Erfassen von Signalen an einer Zündanlage mit den kennzeichnenden Merkmalen des Anspruchs 1 hat den Vorteil, dass die Abschirmung der Sensorelektrode besonders effizient ist. Mit der erfindungsgemäßen Vorrichtung ist vorteilhaft auch im höheren Spannungsbereich der Zündspule eine zuverlässige kapazitive Zündsignalauskopplung und damit eine, höhere Messgenauigkeit des Zündsignals möglich.

Vorteilhafte Ausführungsbeispiele und Weiterentwicklungen der Erfindung sind in den Merkmalen der Unteransprüche enthalten.

Besonders vorteilhaft ist es die Isolierstoffplatte in der bekannten und gut beherrschten Leiterplattentechnik herzustellen. Mit den in der Leiterplattentechnik gebräuchlichen Verfahren zur Herstellung von Leiterbahnen auf einer Isolierstoffplatte, wie z.B. photochemische Verfahren oder Ätzverfahren, können die Leiterbahnen in ihrer Form und Größe auf sehr einfache und preiswerte Weise an den zur Aufbringung des Adapters vorgesehenen Messpunkt der Zündspule angepasst werden. Auf diese Weise ist insbesondere eine Massenfertigung des Adapters preisgünstig durchführbar.

Besonders vorteilhaft ist ein Ausführungsbeispiel der Vorrichtung bei dem der Adapter eine weitere Isolierstoffplatte aufweist, welche auf die mit den Leiterbahnen versehene Seite der auf der Zündspule angeordneten Isolierstoffplatte aufgebracht ist, wobei die weitere Isolierstoffplatte auf ihrer von der Zündspule abgewandten Außenseite mit einer dritten Leiterbahn versehen ist, die über wenigstens eine Durchmetallisierung mit der zweiten Leiterbahn elektrisch leitend verbunden ist. Durch die dritte Leiterbahn, welche mit der zweiten Leiterbahn elektrisch leitend verbunden ist und damit ebenfalls auf Massepotential liegt, wird zusätzlich vorteilhaft erreicht, daß die Sensorelektrode auf der von der Zündspule abgewandten Seite gegen die Einstrahlung von elektromagnetischen Störsignalen (EMV-Schutz) geschützt ist. Zur Erzielung einer besonders guten Abschirmung ist vorgesehen, daß die dritte Leiterbahn die Außenseite des Adapters nahezu vollständig bedeckt. Der mit der ersten, zweiten und dritten Leiterbahn versehene Adapter kann preiswert als Mehrlagen-Leiterplatte hergestellt werden.

Ist der Adapter als Mehrlagen-Leiterplatte ausgebildet, so kann ein elektrischer Anschluß der Sensorelektrode an eine Diagnoseschaltung vorteilhaft dadurch erreicht werden, daß die zwischen den beiden Isolierstoffplatten eingebettete erste Leiterbahn über eine in der weiteren Isolierstoffplatte angeordnete zweite Durchmetallisierung mit einer Kontaktfläche leitend verbunden ist, die auf der von der Zündspule abgewandten Außenseite der weiteren Isolierstoffplatte von der dritten Leiterbahn isoliert angeordnet ist. Die Kontaktfläche ist von außen zugänglich und kann beispielsweise mit einem Anschlußkabel verlötet werden. Die dritte Leiterbahn, welche die Kontaktfläche umgibt, bewirkt dabei gleichzeitig einen Schutz der Kontaktfläche vor Störströmen und Überspannungen.

Vorteilhaft kann die dritte Leiterbahn noch mit einer Isolierschutzbeschichtung, insbesondere einem Isolierlack, beschichtet sein. Die Isolierlackbeschichtung dient als Berührungsschutz gegen spannungsführende Teile.

### Zeichnungen

Ausführungsbeispiele der Erfindung sind in den Zeichnungen dargestellt und werden in der nachfolgenden Beschreibung näher erläutert. Es zeigt
Fig. 1a eine Draufsicht auf ein erstes Ausführungsbeispiel der erfindungsgemäßen Vorrichtung,
Fig. 1b die Vorrichtung aus Fig. 1a im Querschnitt,
Fig. 2a in einem zweiten Ausführungsbeispiel eine Ansicht einer inneren Lage einer als Mehrlagen-Leiterplatte hergestellten erfindungsgemäßen Vorrichtung,
Fig. 2b einen Querschnitt durch die Vorrichtung aus Fig. 2a,
Fig. 2c eine Draufsicht auf die Mehrlagen-Leiterplatte aus Fig. 2b,
Fig. 3 die an einer Zündspule angeordnete erfindungsgemäße Vorrichtung aus Fig. 1,
Fig. 4 ein Schaltbild der erfindungsgemäßen Vorrichtung.

### Beschreibung der Ausführungsbeispiele

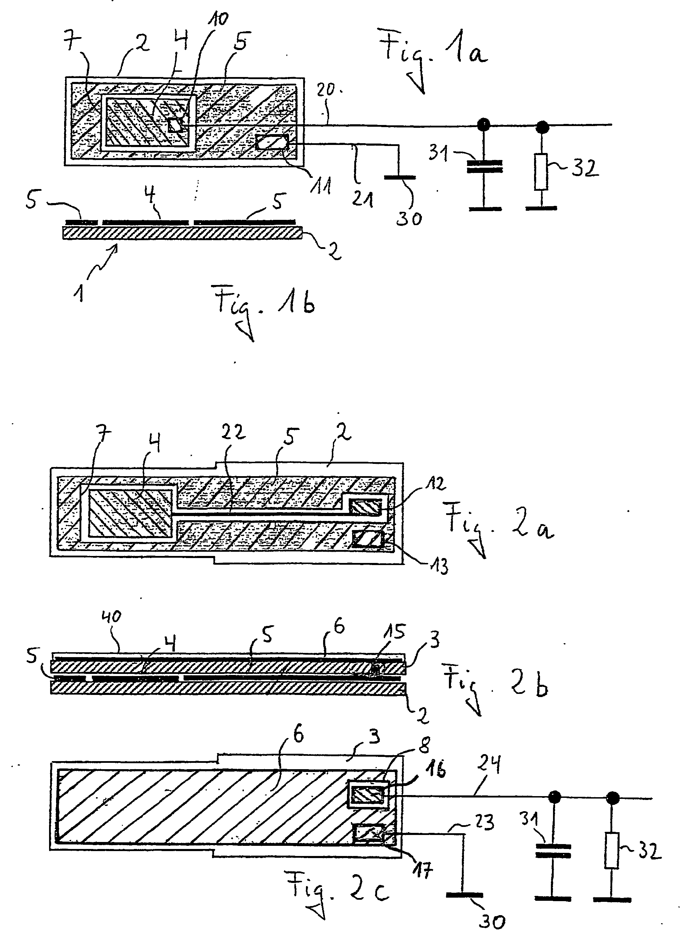

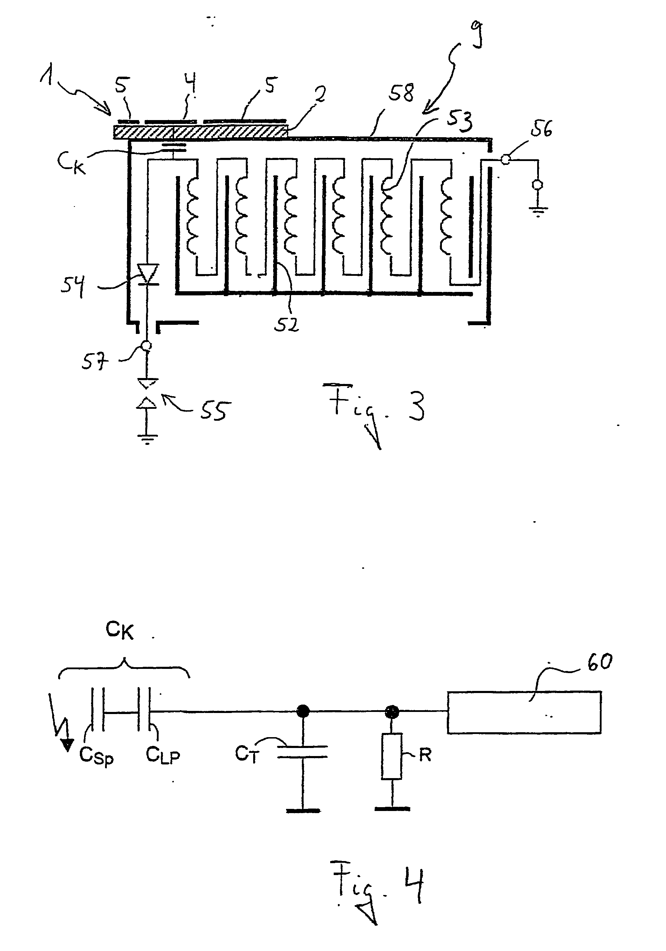

Fig. 3 zeigt schematisch eine an sich bekannte Zündspule 9 einer Zündanlage. Die Zündspule umfaßt eine in Fig. 3 nicht dargestellte, mit einer Gleichspannungsquelle niedriger Spannung verbundene Primärwicklung und eine die Primärwicklung konzentrisch umgebende Sekundärwicklung 53 mit Kammerwicklung. In Fig. 3 sind die Kammern 52 der Sekundärwicklung angedeutet. Die Sekundärwicklung 53 weist einen Masseanschluß 56 und einen mit einer Zündanlage 55, beispielsweise einer Zündkerze, verbundenen Anschluß 57 auf. Eine Diode 54 dient in bekannter Weise zur Unterdrückung der Einschaltfunkenspannung beim Einschalten des Primärstromes. Die Primärwicklung und die Sekundärwicklung sind in bekannter Weise in eine Isolierstoffumhüllung eingebettet, welche die Zündspule nach außen isoliert und zugleich die Außenwand 58 der Zündspule 9 bildet.

Auf der Außenwand 58 der Zündspule ist in der Nähe der letzten Kammerwicklung ein Adapter 1 angeordnet, mit dem eine kapazitive Signalauskopplung des Zündsignals möglich ist. Die kapazitive Kopplung ist in der Fig. 3 durch einen Kondensator C_{K} angedeutet, der als separates elektrisches Bauteil nicht vorhanden ist. Vielmehr wird der Kondensator durch die Sekundärwicklung 53, die Sensorelektrode 4 des Adapters 1 und die dazwischen liegenden Isolierschichten gebildet. Wie in Fig. 1a und Fig. 1b dargestellt ist, umfaßt der Adapter 1 eine Isolierstoffplatte 2, auf deren von der Zündspule 9 abgewandten Seite eine erste Leiterbahn 4 und eine zweite Leiterbahn 5 angeordnet sind. Wie in Fig. 1a zu erkennen ist, ist die erste Leiterbahn 4 von der zweiten Leiterbahn 5 vollständig umgeben und durch einen Spalt 7 von der zweiten Leiterbahn elektrisch isoliert. Die erste Leiterbahn 4 bildet eine Sensorelektrode, während die zweite Leiterbahn 5 zur Abschirmung der Sensorelektrode 4 vorgesehen ist. Wie in Fig. la weiterhin dargestellt ist, ist ein Anschlußbereich 10 der Sensorelektrode mit einer Leitungsverbindung 20, beispielsweise einem Kabelanschluß verbunden. Ein Anschlußbereich 11 der zweiten Leiterbahn 5 ist über eine zweite Leitungsverbindung 21 mit einem Masseanschluß 30 verbunden. Das von der Sensorelektrode 4 erfaßte Zündsignal wird über die Leitungsverbindung 20 einer elektronischen Auswerteschaltung zur Diagnose des Zündsignals zugeführt. Über den Kondensator 31, der mit der Koppelkapazität C_{K} als kapazitiver Spannungsteiler wirkt, wird die ausgekoppelte Signalspannung auf die Eingangsbedingungen der Diagnoseschaltung abgeglichen. Mit dem Widerstand 32 wird die Zeitkonstante für die Signalübertragung abgestimmt. Während des Betriebs der Zündspule auftretende Störströme und Überspannungen werden auf die zweite Leiterbahn 5 übertragen und von dort auf Masse abgeleitet.

Der in Fig. 1a und 1b dargestellte Adapter ist in Leiterplattentechnik hergestellt mit einer Isolierstoffplatte 2 aus beispielweise Epoxidharz und darauf angeordneten Kupferleiterbahnen. Es sind aber auch andere Ausführungen möglich, beispielsweise Isolierstoffsubstrate aus Keramik. Die Isolierstoffplatte 2 wird zur Zündsignalauskopplung direkt auf die Außenseite 58 der Zündspule 9 aufgebracht, beispielsweise aufgeklebt. Besonders gute Ergebnisse werden erzielt, wenn zwischen der Isolierstoffplatte 2 und der Zündspule 9 kein Luftspalt und keine Lufteinschlüsse vorhanden sind.

In Fig. 2a bis 2c ist eine weiteres Ausführungsbeispiel der erfindungsgemäßen Vorrichtung dargestellt, wobei der Adapter 1 als Mehrlagen-Leiterplatte ausgebildet ist. Das Ausführungsbeispiel in Fig. 2b unterscheidet sich von dem Ausführungsbeispiel in Fig. 1b dadurch, daß auf der mit den Leiterbahnen 4,5 versehenen Seite der Isolierstoffplatte 2 eine weitere Isolierstoffplatte 3 mit einer dritten Leiterbahn 6 angeordnet ist, welche die von der Zündspule 9 abgewandte Außenseite des Adapters großflächig abdeckt, wie am besten in Fig. 2c zu erkennen ist. Auf diese Weise wird eine noch bessere Abschirmung der Sensorelektrode 4 erreicht. Die dritte Leiterbahn 6 ist über eine Durchmetallisierung oder Durchkontaktierung 15 mit der zweiten Leiterbahn 5 verbunden. Ein Anschlußbereich 17 der dritten Leiterbahn 6 ist über eine Leitungsverbindung 23 mit Masse 30 verbunden, so daß sowohl die dritte Leiterbahn 6 als auch die zweite Leiterbahn 5 auf Massepotential befindlich sind. Die zwischen den Isolierstoffplatten 2,3 eingebettete erste Leiterbahn 4 ist über einen schmalen Leiterbahnabschnitt 22 mit einer Kontaktfläche 12 verbunden, welche über eine nicht dargestellte, in der weiteren Isolierstoffplatte 3 angeordnete zweite Durchmetallisierung oder Durchkontaktierung mit einer Kontaktfläche 16 auf der Außenseite des Adapters 1 verbunden ist. Die Kontaktfläche 16 ist in einer Aussparung der dritten Leiterbahn 6 angeordnet und durch einen Spalt 8 von der dritten Leiterbahn 6 isoliert sowie über eine Leitungsverbindung 24 mit der Auswerteschaltung verbunden.

Fig. 4 zeigt ein Schaltbild des Adapters aus Fig. 1b oder 2b. Die Koppelkapazität C_{K} für die Signalauskopplung wird durch die Kapazität C_{Sp} der Zündspule 9 und die Kapazität C_{Lp} der Leiterplatte 2 gebildet. Über den Kapazitätenteiler C_{T} wird die Spannungshöhe verkleinert und das ausgekoppelte Zündsignal der Diagnoseschaltung 60 zugeführt. Mit dem Widerstand R wird die Zeitkonstante der Eingangsschaltung auf die Signalübertragung abgestimmt (Signaltreue).

## Patentansprüche

1. Vorrichtung zum Erfassen von Signalen an einer Zündanlage, welche wenigstens eine Zündspule (9) aufweist, wobei ein mit wenigstens einer Sensorelektrode (4) versehener Adapter (1) an der Zündspule (9) für eine kapazitive Signalauskopplung festlegbar ist, **dadurch gekennzeichnet, dass** der Adapter (1) eine Isolierstoffplatte (2) umfasst, die auf der von der Zündspule (9) abgewandten Seite mit einer die Sensorelektrode (4) bildenden ersten Leiterbahn (4) und mit einer die erste Leiterbahn (4) vollständig umgebenden und durch einen Spalt (7) von der ersten Leiterbahn (4) isolierten zweiten Leiterbahn (5) versehen ist, welche zweite Leiterbahn (4) mit einem Masseanschluß (30) elektrisch verbunden ist.

2. Vorrichtung nach Anspruch 1, **dadurch gekennzeichnet, daß** die Isolierstoffplatte (2) eine Leiterplatte ist.

3. Vorrichtung nach Anspruch 1, **dadurch gekennzeichnet, daß** der Adapter (1) eine weitere Isolierstoffplatte (3) aufweist, welche auf die mit den Leiterbahnen (4,5) versehene Seite der Isolierstoffplatte (2) aufgebracht ist, wobei die weitere Isolierstoffplatte (3) auf ihrer von der Zündspule (9) abgewandten Außenseite mit einer dritten Leiterbahn (6) versehen ist, die über wenigstens eine Durchmetallisierung (15) mit der zweiten Leiterbahn (5) elektrisch leitend verbunden ist. (Fig. 2b)

4. Vorrichtung nach Anspruch 3, **dadurch gekennzeichnet, daß** die dritte Leiterbahn (6) die Außenseite des Adapters nahezu vollständig bedeckt.

5. Vorrichtung nach Anspruch 3, **dadurch gekennzeichnet, daß** der Adapter (1) eine Mehrlagen-Leiterplatte ist.

6. Vorrichtung nach Anspruch 3, **dadurch gekennzeichnet, daß** die erste Leiterbahn (4) über eine in der weiteren Isolierstoffplatte (3) angeordnete zweite Durchmetallisierung mit einer Kontaktfläche (16) leitend verbunden ist, die auf der von der Zündspule (9) abgewandten Außenseite der weiteren Isolierstoffplatte (3) von der dritten Leiterbahn (6) isoliert angeordnet ist. (Fig. 2a, 2c)

7. Vorrichtung nach Anspruch 3, **dadurch gekennzeichnet, daß** die dritte Leiterbahn (6) mit einer Isolierschutzbeschichtung (40), insbesondere einem Isolierlack beschichtet ist.

## Claims

1. Apparatus for detecting signals on an ignition system which has at least one ignition coil (9), it being possible to fix an adapter (1) which is provided with at least one sensor electrode (4) to the ignition coil (9) for capacitive signal extraction, **characterized in that** the adapter (1) comprises an insulating plate (2) which is provided, on the side which faces away from the ignition coil (9), with a first conductor track (4) which forms the sensor electrode (4), and with a second conductor track (5) which completely surrounds the first conductor track (4) and is insulated from the first conductor track (4) by a gap (7), the said second conductor track (4) being electrically connected to an earth connection (30).

2. Apparatus according to Claim 1, **characterized in that** the insulating plate (2) is a printed circuit board.

3. Apparatus according to Claim 1, **characterized in that** the adapter (1) has a further insulating plate (3) which is fitted on that side of the insulating plate (2) which is provided with the conductor tracks (4, 5), the further insulating plate (3) being provided, on its outer side which faces away from the ignition coil (9), with a third conductor track (6) which is electrically conductively connected to the second conductor track (5) via at least one plated-through hole (15). (Fig. 2b)

4. Apparatus according to Claim 3, **characterized in that** the third conductor track (6) almost completely covers the outer side of the adapter.

5. Apparatus according to Claim 3, **characterized in that** the adapter (1) is a multilayer printed circuit board.

6. Apparatus according to Claim 3, **characterized in that** the first conductor track (4) is conductively connected to a contact area (16) via a second plated-through hole which is arranged in the further insulating plate (3), the said contact area being arranged on the outer side of the further insulating plate (3) which faces away from the ignition coil (9) such that it is insulated from the third printed circuit board (6). (Figs 2a, 2c)

7. Apparatus according to Claim 3, **characterized in that** the third conductor track (6) is coated with an insulating protective coating (40), in particular an insulating enamel.

## Revendications

1. Dispositif d'enregistrement de signaux au niveau d'un circuit d'allumage présentant au moins une bobine d'allumage (9), un adaptateur (1) pourvu d'au moins une électrode de détection (4) fixé à la bobine d'allumage (9) pour un découplage de signal capacitif,
**caractérisé en ce que**
l'adaptateur (1) comprend une plaque isolante (2) qui, sur son côté tourné vers la bobine d'allumage (9), est pourvue d'une première piste de circuit imprimé (4) formant l'électrode de détection (4), et d'une deuxième piste de circuit imprimé (5) entourant complètement la première piste de circuit imprimé (4) et isolée de la première piste de circuit imprimé (4) par une fente (7), la deuxième piste de circuit imprimé (5) étant reliée électriquement à la masse (30).

2. Dispositif selon la revendication 1,
**caractérisé en ce que**
la plaque isolante (2) est une plaquette de circuit imprimé.

3. Dispositif selon la revendication 1,
**caractérisé en ce que**
l'adaptateur (1) présente une autre plaque isolante (3) appliquée sur la plaque isolante (2) pourvue des pistes de circuit imprimé (4, 5), l'autre plaque isolante (3) étant pourvue, sur son côté extérieur opposé à la bobine d'allumage (9), d'une troisième piste conductrice (6) reliée de façon conductrice, via au moins une métallisation (15), à la deuxième piste de circuit imprimé (5) (figure 2b).

4. Dispositif selon la revendication 3,
**caractérisé en ce que**
la troisième piste conductrice (6) recouvre presque complètement le côté extérieur de l'adaptateur.

5. Dispositif selon la revendication 3,
**caractérisé en ce que**
l'adaptateur (1) est une plaquette de circuit imprimé à plusieurs couches.

6. Dispositif selon la revendication 3,
**caractérisé en ce que**
la première piste de circuit imprimé (4) est reliée de façon conductrice à une surface de contact (16) par l'intermédiaire d'une deuxième métallisation disposée dans l'autre plaque isolante (3), la surface de contact étant disposée sur le côté extérieur, opposé à la bobine d'allumage (9), de l'autre plaque isolante (3), de façon isolée par rapport à la troisième piste de circuit imprimé (6) (figures 2a, 2c).

7. Dispositif selon la revendication 3,
**caractérisé en ce que**
la troisième piste de circuit imprimé (6) est revêtue d'une couche de protection isolante, en particulier d'une laque isolante.
